Europäisches Patentamt

European Patent Office

Office européen des brevets

(11) Publication number: 0 180 220 B1

# EUROPEAN PATENT SPECIFICATION

(45) Date of publication of patent specification: 02.09.92

(51) Int. Cl.⁵: **B32B 31/26**, B32B 15/08, H05K 3/02, H05K 3/00

(21) Application number: 85113861.0

(22) Date of filing: 31.10.85

Divisional application 91115895.4 filed on 31/10/85.

(54) A process for producing metal clad thermoplastic base materials.

(30) Priority: 02.11.84 US 667884
21.02.85 US 703942

(43) Date of publication of application:
07.05.86 Bulletin 86/19

(45) Publication of the grant of the patent:
02.09.92 Bulletin 92/36

(84) Designated Contracting States:
FR GB IT

(56) References cited:
EP-A- 0 089 387      FR-A- 2 430 165
GB-A- 1 492 474      GB-A- 2 057 351
GB-A- 2 101 526      US-A- 2 972 003
US-A- 3 616 014

(73) Proprietor: AMP-AKZO CORPORATION (a Delaware corp.)
710 Dawson Drive
Newark, Delaware 197113(US)

(72) Inventor: Frisch, David C.
476 Seaman Avenue
Baldwin, NY 11510(US)
Inventor: Weber, Wilhelm
54 Ninth Street
Hicksville, NY 11801(US)

(74) Representative: Königseder-Egerer, Claudia D.
Zugspitzstrasse 65
W-8104 Grainau(DE)

**Description**

This invention relates to laminating a metal foil or sheet to a thermoplastic polymer substrate at a preselected temperature.

High temperature engineering thermoplastics, such as polysulfones, polyethersulfones, polyarylsulfones and polyetherimides have excellent dielectric properties. Many processes have been proposed for producing printed circuit conductors on such thermoplastic materials. Printed circuit conductors or patterns have been produced on adhesion promoted non-metal clad thermoplastic materials employing the additive as well as the semi-additive process.

Over 90% of all printed circuits are, however, produced by subtractive processes, starting with a copper clad base material. Printed circuit manufacturing facilities employing subtractive manufacturing processes, in general, do not have additive or semi-additive manufacturing capabilities.

Since 1977, the printed circuit industry has sought high temperature thermoplastics as base materials. See, e.g., Modern Plastics, June 1977, pp. 52-54 "New Day Dawns for Circuit Boards". Widescale manufacture to fill this need has not been possible due to the lack of suitable copper clad, high temperature, thermoplastic base materials. Naegle, IPC-TP-319, The Institute for Interconnecting and Packaging Electronic Circuits, April 1980 "Polysulfone: Its Microwave Properties", describes two types of copper clad polysulfone. In one type, copper foil is directly bonded to a polysulfone sheet. However, Naegle does not describe how this direct bonded copper clad polysulfone was prepared, and it has not been made available commercially. In the second type, copper foil is bonded to the polysulfone substrate by an intermediate layer of pre-preg, epoxy resin impregnated glass cloth. The adhesion of the copper foil to the base material is superior in this second type but all other properties are described as inferior. The second type was commercially available, but it was subsequently withdrawn from the market.

Going "Polyetherimide: A New High Performance Polymer for Printed Circuit Applications", Oct. 1982 Meeting of American Society for Electroplated Plastics, describes the formation of copper clad polyetherimide substrates. Going recommends laminating copper foil to a polyetherimide base material at temperatures of 260°C to 288°C and pressures of 3.5 MPa (500 psi) or less. The copper-polyetherimide base material produced by this procedure is not completely satisfactory, due to the stress and flow of the resin during lamination. The laminate has a tendency to warp after subtractive printed circuit processing and to have thickness variations from place to place on the base material.

EP-A-0089387 claims the preparation of copper-clad laminates, which may be utilized in the circuit board production, consisting of at least one thermoplastic resin sheet with a glass transition temperature of about 170°C and a sheet of high profile copper. The laminate of EP-A-0089387 possesses desirable characteristics. "High profile copper", in accordance to the definition given on page 5, lines 5 to 9, is a "copper foil or sheet which is smooth on one side and rough on the other side". Most obviously, this special copper is of utmost importance for achieving good results. The stringent use of "high profile copper" instead of regular copper foils or sheets as in the present application adds undesirable time and cost to the process of EP-A-0089387. Furthermore, as no indication is given about the content of organic volatiles to be below 0,1%, blisters are to be expected when the substrate is exposed to temperatures above 250°C for periods of time sufficient for reliable solder joints.

GB-A-2101526 claims an aromatic imide polymer laminate material consisting of at least one aromatic imide polymer film and at least one metallic foil directly bonded to the aromatic imide polymer film. This invention is mainly concerned with the preparation of the polyimide film. During the preparation of the laminate, an intermediate product is formed which is a polyamide acid film. This film is exposed to a heat treatment for conversion into an aromatic imide polymer. No further heating step is mentioned neither before nor after the laminating step. The crucial condition that the volatile content of such foil should be below 0,1% is not mentioned. Blistering of the material is to be expected during the soldering process.

It is an object of this invention to provide an improve process for the manufacture of metal clad thermoplastic laminates.

By the term "High temperature thermoplastic" is meant a polymer article having an aromatic backbone that does not liquify or decompose when exposed for 5 seconds to molten solder at 245°C. By the term "heat distortion temperature" is meant the deflection temperature of a polymer under flexural load measured by ASTM Standard D 648 at 1.82 MPa load. The terms "base material", "printed circuit", "printed circuit pattern", "printed circuit board" have the meaning assigned by ANSI/IPC-T-50B.

The process of the present invention for the production of a metal clad thermoplastic polymer substrate for the manufacture of printed circuits comprises the steps of superimposing a metal foil or sheet on a thermoplastic polymer film or sheet and consolidating the assembly so produced by applying heat and pressure and is characterized in that the thermoplastic polymer is heated to a temperature below 165°C for at least 30 minutes to reduce the amount of absorbed volatiles having boiling points below 245°C to less than 0.1%; and that the assembly is consolidated by applying pressure of between 1 and 10 MPa at a temperature of 2°C to 45°C above the glass transition temperature (Tg) of the thermoplastic polymer for a time period sufficient to firmly laminate the metal foil or sheet to the thermoplastic polymer film or sheet; and that after said consolidation step the metal clad laminate is annealed at a temperature from 50°C below the heat distortion temperature of the thermoplastic polymer up to the heat distortion temperature to stress relieve the said laminate. The laminates produced by this process do not warp in processing and are produced with an overall uniform thickness.

Volatiles removed or reduced to less than 0.1% before laminating a metal layer to the polymer substrate include residual moisture and/or solvent present in the thermoplastic polymer substrate. Preferably, the volatiles are removed by heating at a temperature between 110°C and 130°C for a time period between 2 hours and 24 hours Laminating pressures between 1 and 10 MPa, and preferably between 3 and 7 MPa are employed, with the time period for the lamination, i.e., between 1 and 60 minutes and preferably between 3 and 30 minutes. Preferably, the assembly is consolidated at a temperature between 5°C and 35°C, and most preferably between 15°C and 30°C, above the Tg of the thermoplastic polymer.

After the metal layer has been laminated to the thermoplastic polymer film or sheet, the formed laminates flat (not warped) and of substantially uniform thickness. When a metal pattern is etched on such metal clad thermoplastic polymer laminate, it may crack, craze and/or become warped. Therefore, in accordance with the invention, before providing the metal clad thermoplastic laminate with an etched metal conductor pattern, the metal clad laminate is relieved of internal stresses by raising it to a temperature at or just below the heat distortion temperature of the thermoplastic polymer . This may be conveniently accomplished directly after forming the metal clad laminate. The laminate or a stack of the laminates is preferably restrained between two flat surfaces during the stress relieving step, but only a slight pressure is applied, which pressure is sufficient to keep the flat surfaces in contact with the metal clad laminate.

The bond strengths between copper foil and high temperature thermoplastic film or foil which has been laminated and stress relieved by the process of this invention, were measured. The results are shown in Table 1 below.

Table 1

| Thermoplastic Polymer | Bond Strength (kg/mm) (N/mm) |
|---|---|
| Polysulfone | 0,09 - 0,13 (0,9 - 1,3) |
| Polyethersulfone | 0,09 - 0,13 (0,9 - 1,3) |
| Polyetherimide | 0,14 - 0,25 (1,4 - 2,5) |

For illustrative purposes, the process of the invention is described below in connection with the preparation of a printed circuit board employing subtractive processes including printing a positive image of the circuit pattern on the metal cladding and removing the exposed metal areas by etching thus forming the desired circuit pattern. For printed circuits with conductor patterns on at least two parallel planes connected by plated-through holes, the subtractive processes may include the steps of forming through holes, metallizing the through hole walls and etching to form the circuit conductor patterns.

Unlike subtractive processes for manufacturing plated-through holes in conventional printed circuit base materials, e.g., copper clad epoxy glass laminate, carrying out subtractive processes using thermoplastic base materials according to this invention, hole walls formed in the thermoplastic are preferably adhesion promoted before metallizing same. When attempts are made to manufacture plated-through holes in thermoplastic base materials without such step, the metal layer often does not adhere to the hole walls. This produces blistering or separation of the metal from the hole walls and even may cause metal flaking from the hole walls, leaving voids or otherwise incomplete plated-through holes. Adhesion promotion may be accomplished by well known means such as mechanical roughening, plasma or gas etching, or by strong acids, alkaline or oxidizing solutions.

Suitable metals for the metal layers used in the processes of this invention include copper, nickel, aluminum, silver, gold, and the platinum group metals, and alloys of these metals. The thickness of the metal layer is not critical, and may, e.g., be as low as 5 μm or as high as 5 mm.

The most commonly used metal layer for printed circuit conductors is copper. A copper surface, which will be placed in contact with the base material, should be treated for adhesion. Such treatments include brass and zinc coatings and adherent oxide layers, such as, black oxides and brown oxides.

The process of this invention also is suitable for bonding alternating layers of metal and thermoplastic, e.g., substrates with a reinforced core are useful in making a metal clad thermoplastic with a reinforced metal core. Copper clad thermoplastic substrates with a metal core are useful in making metal core circuit boards and multilayers.

The process of the invention may be used to laminate metal layers to both high and low temperature amorphous thermoplastic polymers. High temperature thermoplastic polymers are preferred for printed circuit boards. Suitable low temperature polymers are believed to include polymethacrylates and acrylonitrile-butadiene-styrene copolymers. The thickness of the polymer substrate may, e.g., be from 0.7 mm to 7 mm. For many printed circuit board applications, 1.5 to 1.6 mm thick polymer sheets are used, but for flexible printed wiring, 0.13 and 0.25 mm thick polymer films may be used.

Many metal foils or sheets contain internal stresses which may have been imparted to the sheets or foils by the electroforming or the rolling process used to manufacture the foils. For example, metal foils which have been electrodeposited contain internal tensile stresses. When thermoplastic polymer films or sheets having a thickness above about 0.7 mm ("thick gauge") are employed in accordance with the invention, the effect of these internal streses is essentially minimized.

Applicants have found, however, that (1) when thermoplastic polymer films or sheets having a thickness below 0.7 mm ("thin gauge") or, (2)when flexible plastic films having a thickness below about 0.5 mm are clad with metal in accordance with the technique described herein for thick gauge thermoplastic polymer films or sheets, the metal clad polymer substrate warps, curls and/or distorts after a printed wire pattern is etched on the metal foil. This warping, curling and/or distortion results due to (1) internal stresses inherent in electrodeposited metal foils and, (2) differences in the thermal coefficients of expansion (TCE) of the metal foil or sheet being clad and the thermoplastic polymer substrate.

Attempts to minimize these undesirable effects by post lamination annealing bakes or by reverse rolling around mandrels have been found to be ineffective with little or no improvement observed.

It has been discovered that the aforementioned undesirable effects of warping, curling and/or distortion can be substantially reduced or even eliminated by the following techniques, alone or in combination.

In one technique, a metal foil or sheet of reduced thickness, e.g., equal to or less than 0.017 mm, is employed. Applicants have discovered that the thickness of the metal cladding not only will reduce the dismatch in TCEs between the metal foil or sheet and the thermoplastic substrate but also will reduce internal stresses in the laminate. The ratio of the thickness of the metal foil or sheet to the thickness of the thermoplastic sheet should be selected to minimize the warping, curling and/or distortion induced by internal stresses and differences in the TECs of the metal foil or sheet and the thermoplastic polymer. For example, with commercially available electrodeposited copper foils and high temperature thin gauge thermoplastic films, applicants prefer a thickness ratio of about 0.03 or below.

In another technique, an annealed metal foil or sheet which is stress-free, such as roll annealed copper 0.035 mm, may be used at a thickness ratio below about 0.1 to substantially minimize or prevent stress induced distortion on thin gauge thermoplastic polymer films. For multilayer printed circuit applications and/or flexible printed circuit applications, a 0.035 mm roll annealed copper cladding is preferred. When subsequent plating is involved, then a thinner gauge copper, e.g., less than 0.017 mm , may be employed.

The preferred amorphous thermoplastic polymers include polysulfones, polyethersulfones, polyarylsulfones and polyetherimides. The choice of a filled or unfilled polymer base material depends on the application.

The process for the manufacture of printed circuits from the thermoplastic polymer substrates disclosed herein is made the subject of the divisional application (application No. 91115895.4)

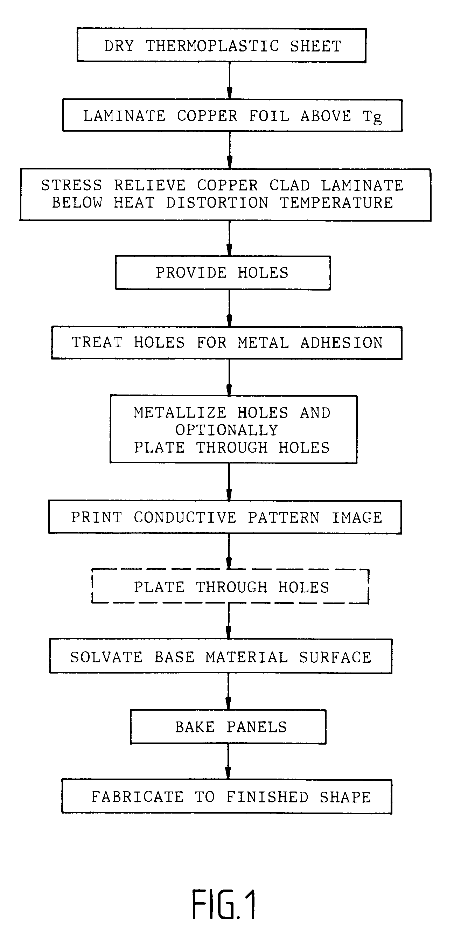

A typical process for the manufacture of double-sided, plated-through hole, printed circuit boards according to this invention is shown in Fig. 1 as a flow chart. The starting material for the process may be extruded sheets of amorphous, thermoplastic resins. For many printed circuit board applications, a sheet with a thickness of 1.6 mm may be used. Since flexible printed wiring also may be prepared by the process of the invention, it is clear that the process is not limited to such a thickness or to extruded sheet base materials.

In the first step of the process, extruded sheets of thermoplastic base material are dried before lamination. The drying temperatures may be as low as 100°C and below 165°C. When thermoplastic sheets are dried individually, the drying time may be very short. However, it is convenient to dry a stack of sheets at once. When drying a stack of sheets, the stack may be dried for two or more hours. It is very convenient to dry a stack of thermoplastic sheets over night at 125°C.

The thermoplastic polymer materials used in the processes of the invention are essentially hydrophobic, not soluble in water, and have low water absorption. It is well known that polymer pellets should be dried before molding or extruding polymer articles. If the polymer pellets are not dried, the presence of water may be detected by streaks and bubbles in the extruded or molded article. However, the extruded or molded polymer articles are essentially non-hydroscopic. Polysulfone articles may absorb up to 0.7% water; polyethersulfone articles up to 1.65%; and polyetherimide articles up to 1.25%. When a metal layer such as copper foil, is applied to both sides of a thermoplastic sheet containing a low percentage of absorbed water, the initial appearance of the laminate is very good. At a later time, especially any time the laminate is subjected to increased temperatures, such as in soldering printed wiring boards at 230°C to 290°C, blisters form between the metal layer and the base material. Surprisingly, this problem is avoided by the mild drying step described above. It also may be eliminated by storing the sheets at less than 50% relative humidity. Thus, the drying step is optional if relative humidity of the storage area is sufficiently low.

In the second step of the process as shown in Fig. 1, the dried sheet is laminated to copper foil at a temperature above the glass transition temperature (Tg) of the amorphous thermoplastic polymer. Typical laminating temperatures are shown in Table 2 below.

Table 2

| Thermoplastic Polymer | Tg (°C) | Laminating Temperatures (°C) at | | |
|---|---|---|---|---|
| | | minimum | Preferred | Maximum |
| Polysulfone | 190 | 215 | 225 | 235 |
| Polyetherimide | 215 | 220 | 230 | 245 |
| Polyarylsulfone | 220 | 230 | 245 | 260 |
| Polyethersulfone | 230 | 235 | 245 | 260 |

An extruded sheet of thermoplastic base material, with sheets of copper foil to be laminated on both sides is placed in a laminating press. When the press is closed and laminating pressure and heat applied to the assembly, the temperature is preferably measured at the surface of the thermoplastic sheet. After the thermoplastic sheet reaches the laminating temperature, the temperature and pressure are maintained for at least one minute and, preferably, at least three minutes in order to firmly laminate the copper foils to the thermoplastic sheet. The lamination pressure is not critical and should be high enough to ensure intimate contact between the thermoplastic polymer sheet and the copper foils, and low enough to prevent thickness variations and squeezing out of a substantial amount of polymer at the edges of the sheet.

After laminating the copper foils to the thermoplastic sheet, about 10 to 12 mm may be trimmed from the edges of the sheet.

The third step of the process shown on the flow chart is heating the copper clad sheet to relieve any stresses set up by the laminating procedure. This is accomplished by heating the laminate to between about the heat distortion temperature of the polymer and about 50°C below the heat distortion temperature, preferably 4°C to 10°C below the heat distortion temperature. The laminate should be held at the stress relieving or annealing temperature as long as required to ensure that when a conductor pattern is etched on the base material, the base material will not crack or craze, and will remain substantially warp-free. The duration of the stress relieving treatment depends on the polymer, the filler and the temperature. Proper times can be determined by etching conductor patterns in copper clad base materials that have been stress relieved at various times for a given temperature. Four hours is a suitable time for stress relief of laminates at the temperatures shown in Table 3 below.

Table 3

| Base Material | Temperature (°C) |
|---|---|
| Polysulfone | 170 |
| Polyetherimide | 195 |
| Polyethersulfone | 200 |

In step 4 as shown in the flow chart, holes for plated-through holes are provided in the copper clad base material.

In step 5, the walls of the holes are treated to promote adhesion of electrolessly formed metal deposits.

One method of treating the hole walls is to promote adhesion by the swell and etch technique. The hole walls are contacted with a solvent mixture such as dimethyl-formamide and isopropanol to swell the surface of the hole walls; the hole walls are then contacted with an oxidizer such as a chromic acid solution or an alkaline permanganate solution. The oxidizing solution is selected to avoid etching the laminated metal layer of the base material. For most layers, an aqueous solution of about 400 to 900 g/l chromium trioxide at 23°C to 60°C may be used; or an aqueous solution of 40 to 60 g/l of potassium permanganate at 40°C to 60°C and having a pH of 12 to 13.5 may also be used.

Alternatively, mechanical treatments like sandblasting, liquid or vapor honing with an abrasive or pumice slurry will sufficiently texture the hole walls so as to render them receptive to adherent electroless metal deposition.

As shown in step 6 of Fig. 1, the hole walls are metallized by well known procedures including activating the hole walls with palladium-tin chloride activators and electrolessly plating a thin film of metal. Alternatively, the hole walls may be activated with non-noble metal activators for electroless deposition.

If the printed wiring board is to be manufactured by the panel plating process, this step would include additional hole wall plating to deposit the finished metal thickness on the hole walls, e.g., 25 $\mu$m of copper.

In step 7, when the hole walls have been adherently metallized, the image of the printed circuit pattern is printed with a resist on the panel. Printing procedures are well known in the art and include both screen printing and photoprinting. Since most of the thermoplastic base materials are sensitive to many solvents, it is preferable to establish the resist image for plating or etching with aqueous strippable resists, which are well known in the art.

The step of plating after imaging is normally employed in the pattern plating process, when the plated-through holes were not plated with the full thickness of metal in step 6.

In the next step, the printed circuit panel may be further processed by well known means. This processing includes etching to remove the unwanted portions of the laminated metal layer between the desired printed circuit pattern conductors.

Subsequent to the removal of the unwanted metal, the bond strength of the conductors, especially the small conductors, is enhanced by contacting the exposed surface of the base material with a solvent for the material and then rapidly evaporating the solvent from the surface in order to flow some of the base material against the edges of the conductors. The surface is contacted with solvent for a time period brief enough to prevent crazing of the surface or flow of solvated base material over the conductors. The evaporation is accomplished at temperatures high enough to rapidly remove the solvent and sufficient to secure a bond between the base material and the edges of the conductors.

The thus achieved enhancement of bond strength may be accomplished by immersing the polymer base material in a solvent in which the polymer is at least partially soluble and for a time period sufficient to solvate the polymer surface but insufficient to result in stress cracking or flow of the polymer onto the metal pattern. The time period will vary between about 1 second and about 1 minute, depending on the solvent system selected and the polymer system being treated. Suitable solvent systems include a strong solvent for the polymer and suitable diluents. Among the diluents are aliphatic hydrocarbons, aliphatic alcohols and water. Immediately after being contacted with the solvent, the polymer surface is dried at a temperature at which the solvent rapidly volatilizes. The drying temperature is from room temperature up to about 200°C depending upon the polymers and the solvent systems used. Preferably, the drying temperature is between room temperature and 125°C.

The immersion may be in a liquid solvent such as ketones, esters, aromatic or aprotic solvents, or in solvent vapors or halogenated hydrocarbons with boiling points below the heat distortion temperature of the polymer.

Immediately upon removal of the polymeric substrate from exposure to the solvent, the polymeric substrate should be dried. Convection or infrared/convection oven combinations may be employed for drying. Solvating the surface enables the surface region of the themoplastic base material to flow against the edges of the conductors. The application of heat in drying the solvated surface improves the flow. Drying temperatures, after exposure to liquid solvents, are preferably between about 60°C and about 200°C.

Prolonged delays after discontinuing solvent exposure and before beginning drying will give rise to a light haze or frosting condition. Properly treated surfaces will appear smooth and even translucent or transparent in the case of unfilled or unpigmented high temperature thermoplastics which are translucent or transparent prior to laminating metal to their surface. Similarly, if a high temperature thermoplastic initially contains a pigment, treatment of its exposed surface will restore its initial color.

The final stages in the manufacture of a printed circuit board are carried out in step 11.

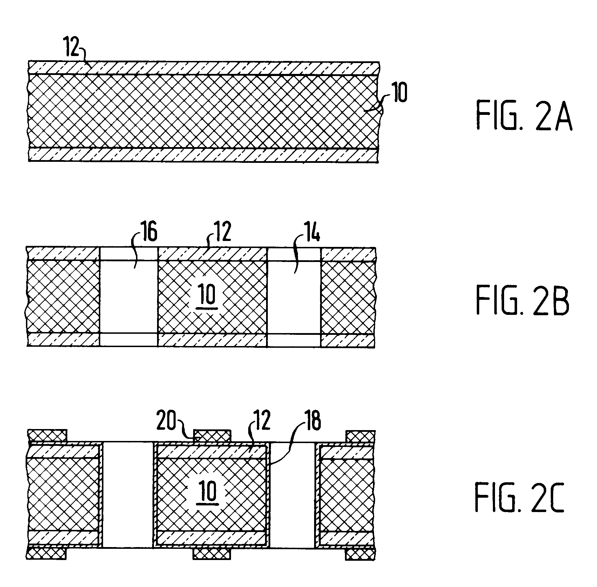

Fig. 2A shows an insulating blank 10 bonded on both sides with copper foil 12. The blank 10 comprises a sulfone polymer.

Fig. 2B shows holes 14 and 16 drilled through the blank 10. As shown in Fig. 2C, after holes 14 and 16 are produced, the blank 10 is metallized including the hole walls with a thin layer of electrolessly deposited copper 18 and printed with a negative resist image 20 for pattern plating.

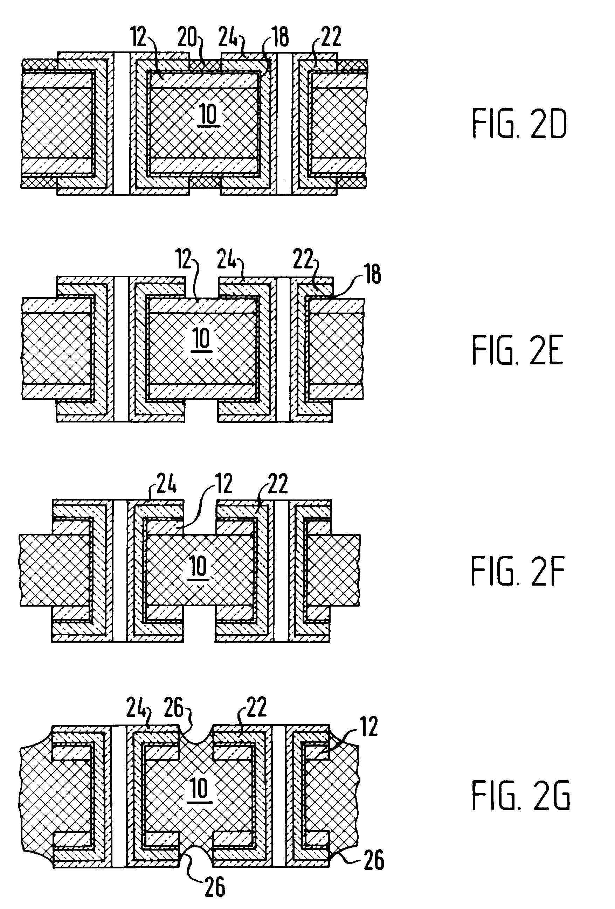

In Fig. 2D, the blank 10 is plated electrolytically with a copper layer 22 and a tin-lead alloy layer 24.

As shown in Fig. 2E, the resist 20 has been removed exposing the underlying copper foil 12 which will be subsequently etched in the next step.

In Fig. 2F, the blank 10 has been immersed in a copper etching solution wherein the copper foil 12 is chemically dissolved thereby delineating the desired circuit conductor pattern.

As shown in Fig. 2G, the blank 10 has been immersed in a solution containing 80% N,N-dimethylformamide and 20% isopropanol. Following removal of the blank from the chemical solution, the solvent has been rapidly volatilized. During the procedure of solvent immersion and rapid drying, the surface layer 26 of the sulfone polymer 10 has flowed up onto the edges of copper circuitry 12 and 22.

EXAMPLE

Six polyetherimide sheets of various thicknesses and a size of 450 mm x 600 mm each were dried overnight at 125°C and laminated on both sides with copper foils of various thicknesses at a temperature of 230°C for 10 minutes at a pressure of 4.3 MPa (633 psi). The laminated materials were heated for four hours at 195°C to relieve any stresses set up by the laminating step. A circuit pattern was applied by print and etch processing.

As shown in Table 4 below, the laminated materials having etched wiring patterns after print and etch processing in which the thickness ratio was below about 0.03 were found to be virtually flat whereas those in which the thickness ratio was above 0.04 were found to be distorted.

Table 4

| | | Electrodeposited Copper Foil | | | |
|---|---|---|---|---|---|
| Sample | Foil Thickness mm | Polyetherimide Base Thickness | | Thickness Ratio Foil/Base | Flatness |
| | | mils | mm | | |
| A | 0.005 | 0.015 | 0.380 | 0.013 | flat |
| B | 0.017 | 0.015 | 0.380 | 0.045 | distorted |
| C | 0.035 | 0.015 | 0.380 | 0.092 | distorted |
| D | 0.017 | 0.030 | 0.760 | 0.022 | virtually flat |
| E | 0.035 | 0.030 | 0.760 | 0.046 | distorted |
| F | 0.035 | 0.045 | 1.140 | 0.030 | flat |

## Claims

1. A process for the production of a metal clad thermoplastic polymer substrate for the manufacture of printed circuits comprising the steps of superimposing a metal foil or sheet on a high temperature thermoplastic polymer film or sheet and consolidating the assembly so produced by applying heat and pressure characterized in that the thermoplastic polymer is heated to a temperature below 165°C for at least 30 minutes to reduce the amount of absorbed volatiles having boiling points below 245°C to less than 0.1%; and that the assembly is consolidated by applying pressure of between 1 and 10 MPa at a temperature of 2°C to 45°C above the glass transition temperature (Tg) of the thermoplastic polymer for a time period sufficient to firmly laminate the metal foil or sheet to the thermoplastic polymer film or sheet; and that after said consolidation step the metal clad laminate is annealed at a temperature from 50°C below the heat distortion temperature of the thermoplastic polymer up to the heat distortion temperature to stress relieve the said laminate.

2. The process of claim 1 characterized in that said volatiles are removed by heating at a temperature between 110°C and 130°C for a time period between 2 hours and 24 hours.

3. The process of claim 1, characterized in that said assembly is consolidated at a temperature between 5°C and 35°C, and preferably between 15°C and 30°C, above the Tg of the thermoplastic polymer.

4. The process of claim 1, characterized in that said thermoplastic polymer film or sheet has a thickness of between 0.7 and 7 mm.

5. The process of claim 1, characterized in that said metal film or sheet has a thickness of between 5 $\mu$m and 5 mm.

6. The process of claim 1, characterized in that said thermoplastic film or foil and/or said metal foil or sheet is (are) adhesion promoted prior to said consolidation.

**Patentansprüche**

1. Ein Verfahren zur Produktion eines metallkaschierten, thermoplastischen Polymerträgers für die Herstellung von gedruckten Schaltungen mit den Schritten des Aufbringens einer Metallfolie oder -platte auf einem Hochtemperatur-Thermoplast-Polymerfilm oder einer -platte und Verfestigen des so hergestellten Laminats durch Anwendung von Hitze und Druck, dadurch gekennzeichnet, daß der Thermoplast-Polymer auf eine Temperatur von unter 165°C für mindestens 30 Minuten erhitzt wird, um den Anteil an flüchtigen Bestandteilen mit Siedepunkten von unter 245°C auf weniger als 0.1% zu reduzieren; und daß das Laminat mit einem Druck von zwischen 1 und 10 MPa bei einer Temperatur von 2 bis 45°C über der Glasumwandlungs-Temperatur (Tg) des Thermoplast-Polymers verfestigt wird, für einen Zeitraum, der ausreicht, um die Metallfolie bzw. - platte mit dem Thermoplast-Polymerfilm oder der -platte fest zu verbinden; und daß im Anschluß an den Verfestigungsschritt das metallkaschierte Laminat getempert wird bei einer Temperatur von 50°C unter der Wärmeverformungs-Temperatur des Thermoplast-Polymers bis zu dessen Formbeständigkeits-Temperatur, um das Laminat zu entspannen.

2. Das Verfahren nach Anspruch 1, dadurch gekennzeichnet, daß die flüchtigen Bestandteile durch Erhitzen auf eine Temperatur zwischen 110°C und 130°C für einen Zeitraum zwischen 2 und 24 Stunden entfernt werden.

3. Das Verfahren nach Anspruch 1, dadurch gekennzeichnet, daß das Laminat bei einer Temperatur zwischen 5°C und 35°C, und vorzugsweise zwischen 15°C und 30°C über der Glasumwandlungs-Temperatur (Tg) des Thermoplast-Polymers verfestigt wird.

4. Das Verfahren nach Anspruch 1, dadurch gekennzeichnet, daß der Thermoplast-Polymerfilm oder die -platte eine Dicke von zwischen 0,7 und 7 mm aufweist.

5. Das Verfahren nach Anspruch 1, dadurch gekennzeichnet, daß der Metallfilm oder die -platte eine Dicke von zwischen 5 $\mu$m und 5 mm aufweist.

6. Das Verfahren nach Anspruch 1, dadurch gekennzeichnet, daß der Thermoplast-Polymerfilm oder die -platte und/oder der Metallfilm oder die -platte vor dem Verfestigen einer Behandlung zur Verbesserung der Haftfestigkeit unterzogen wird bzw. werden.

**Revendications**

1. Procédé pour la production d'un substrat polymère thermoplastique à revêtement métallique, pour fabriquer des circuits imprimés , le procédé comprenant les étapes consistant à superposer une feuille mince ou une feuille de métal sur une pellicule ou une feuille d'un polymère thermoplastique capable de supporter des températures élevées et à soumettre l'ensemble ainsi produit à une consolidation par application d'un chauffage et d'une pression, procédé caractérisé en ce qu'on chauffe le polymère thermoplastique jusqu'à une température inférieure à 165°C pendant au moins 30 minutes pour abaisser à une valeur inférieure à 0,01 % la quantité des matières volatiles absorbées ayant des points d'ébullition inférieure à 245°C; et en ce qu'on consolide l'ensemble en appliquant une pression comprise entre 1 et 10 MPa à une température de 2°C à 45°C au-dessus de la température de transition vitreuse (T$_v$) du polymère thermoplastique , pendant une période de temps suffisante pour fixer fermement par stratification la feuille mince ou feuille de métal sur la pellicule ou feuille du polymère thermoplastique ; et en ce qu'après cette étape de consolidation, on soumet le stratifié comportant un revêtement métallique à un recuit effectué à une température allant de 50°C au-dessous de la température de déformation par chauffage du polymère thermoplastique jusqu'à la température de déformation par chauffage, pour éliminer les contraintes mécaniques de ce stratifié .

2. Procédé selon la revendication 1, caractérisé en ce qu'on enlève les matières volatiles en effectuant un chauffage à une température comprise entre 110°C et 130°C pendant une période de temps comprise entre 2 et 24 heures.

3. Procédé selon la revendication 1, caractérisé en ce qu on consolide ledit ensemble en opérant à une température comprise entre 5°C et 35°C et de préférence entre 15°C et 30°C , au-dessus de la température de transition vitreuse ($T_v$) du polymère thermoplastique .

4. Procédé selon la revendication 1, caractérisé en ce que la pellicule ou feuille de polymère thermoplastique a une épaisseur comprise entre 0,7 et 7 mm.

5. Procédé selon la revendication 1, caractérisé en ce que la dite pellicule ou feuille de métal a une épaisseur comprise entre 5 micromètres et 5 mm. 6. Procédé selon la revendication 1, caractérisé en ce que la pellicule ou feuille thermoplastique et/ou la feuille mince ou feuille de métal est ou sont soumise(s) à un traitement favorisant l'adhérence avant ladite opération de consolidation de l'ensemble.

```
┌─────────────────────────────────┐
│     DRY  THERMOPLASTIC  SHEET     │
└─────────────────────────────────┘
                 │
                 ▼
┌─────────────────────────────────┐
│  LAMINATE  COPPER  FOIL  ABOVE  Tg │
└─────────────────────────────────┘
                 │
                 ▼
┌─────────────────────────────────┐
│  STRESS  RELIEVE  COPPER  CLAD  LAMINATE │
│  BELOW  HEAT  DISTORTION  TEMPERATURE    │
└─────────────────────────────────┘
                 │
                 ▼
┌─────────────────────────────────┐
│          PROVIDE  HOLES          │
└─────────────────────────────────┘
                 │
                 ▼
┌─────────────────────────────────┐
│   TREAT  HOLES  FOR  METAL  ADHESION │
└─────────────────────────────────┘
                 │
                 ▼
┌─────────────────────────────────┐
│       METALLIZE  HOLES  AND       │
│            OPTIONALLY             │
│       PLATE  THROUGH  HOLES       │
└─────────────────────────────────┘
                 │
                 ▼
┌─────────────────────────────────┐
│   PRINT  CONDUCTIVE  PATTERN  IMAGE │
└─────────────────────────────────┘
                 │
                 ▼
┌ ─ ─ ─ ─ ─ ─ ─ ─ ─ ─ ─ ─ ─ ─ ─ ─ ┐
      PLATE  THROUGH  HOLES
└ ─ ─ ─ ─ ─ ─ ─ ─ ─ ─ ─ ─ ─ ─ ─ ─ ┘
                 │
                 ▼
┌─────────────────────────────────┐
│  SOLVATE  BASE  MATERIAL  SURFACE │
└─────────────────────────────────┘
                 │
                 ▼
┌─────────────────────────────────┐
│           BAKE  PANELS           │
└─────────────────────────────────┘
                 │
                 ▼
┌─────────────────────────────────┐
│   FABRICATE  TO  FINISHED  SHAPE  │
└─────────────────────────────────┘
```

FIG.1

FIG. 2A

FIG. 2B

FIG. 2C

FIG. 2D

FIG. 2E

FIG. 2F

FIG. 2G